# EUROPÄISCHE PATENTSCHRIFT

(11) **EP 0 826 973 B1**
(45) Veröffentlichungstag und Bekanntmachung des Hinweises auf die Patenterteilung: **10.01.2007**
(21) Anmeldenummer: 97113380.6
(22) Anmeldetag: 02.08.1997
(51) Int. Cl.: G01R 31/01, G05B 19/418

(54) **Verfahren zur Prüfung einer Vielzahl von Produkten**
Procedure for testing a multiple quantity of products
Procédé de test d'une quantité multiple de produits

(30) Priorität: 10.08.1996 DE 19632364
(43) Veröffentlichungstag der Anmeldung: 04.03.1998
(73) Patentinhaber: ATMEL Germany GmbH, 74072 Heilbronn (DE)
(72) Erfinder: Gutmann, Ralf, 74249 Jagsthausen (DE); Jäger, Rolf, 74388 Talheim (DE)

(56) Entgegenhaltungen:
- SCHLOSKE A: "CAQ-SYSTEME" MICROTECNIC, Nr. 1, 1. Januar 1993, Seiten 26-29, XP000334950
- JESCHKE K ET AL: "DIE BEST TESTSTRATEGIE HERAUSFINDEN PROGRAMM AUF PC-BASIS VERHILFT ZUR OPTIMIERUNG" ELEKTRONIK, Bd. 42, Nr. 23, 16. November 1993, Seiten 52-55, XP000414805
- HEISECKE I: "DYNAMISIERTE WARENEINGANGSPRUEFUNG ELEKTRONISCHER KOMPONENTEN" ELEKTROTECHNISCHE ZEITSCHRIFT - ETZ, Bd. 111, Nr. 14, 1. Juli 1990, Seiten 730, 732, 733-735, XP000148340
- DURAKBASA N M: "MESSTECHNIK UND RUCKVERFOLGBARKEIT IN DER QUALITATSSICHERUNG" ELEKTROTECHNIK UND INFORMATIONSTECHNIK, Bd. 111, Nr. 4, 1. Januar 1994, Seite 185/186 XP000447744
- SINGH A D ET AL: "ON OPTIMIZING VLSI TESTING FOR PRODUCT QUALITY USING DIE-YIELD PREDICTION" IEEE TRANSACTIONS ON COMPUTER AIDED DESIGN OF INTEGRATED CIRCUITS AND SYSTEMS, Bd. 12, Nr. 5, 1. Mai 1993, Seiten 695-709, XP000386022

## Beschreibung

Alle komplexen Produkte bzw. alle mittels eines komplexen Herstellungsprozesses gefertigten Produkte sollten bzw. müssen vom Hersteller und/oder vom Anwender vor deren Einsatz einer Prüfung, beispielsweise einer Funktionsprüfung oder Parameterprüfung, unterzogen werden; dies ist insbesondere für Halbleiterbauelemente von Bedeutung, da diese einerseits in großen Stückzahlen hergestellt und andererseits vielfach in sicherheitsrelevanten Anwendungsbereichen eingesetzt werden (beispielsweise integrierte Schaltkreise im Kfz-Bereich für ABS-, Airbag-, Zündung-Baugruppen). Die Prüfung dieser Produkte, beispielsweise der zu verifizierenden spezifischen Eigenschaften, wird vom Hersteller in der Regel in den Ablauf des Herstellungsprozesses integriert und in mindestens einem Prüfmodus zu Beginn des Herstellungsprozesses und/oder während des Herstellungsprozesses und/oder nach Ende des Herstellungsprozesses in einem Prüfungsablauf mit sukzessiven Prüfvorgängen bei einer Vielzahl von Produkten durchgeführt; meist wird dabei zumindest ein Prüfmodus zu Beginn oder während des Herstellungsprozesses der Produkte und ein Prüfmodus nach Ende des Herstellungsprozesses (nach der Fertigstellung) der Produkte durchgeführt - beispielsweise wird beim Herstellungsprozeß von Halbleiterbauelementen üblicherweise ein Prüfmodus der Halbleiterelemente auf der Halbleiterscheibe (dem Wafer) als sogenanntes "Proben" und ein Prüfmodus der fertig montierten und aufgebauten Halbleiterbauelemente als sogenanntes "Endmessen" vorgenommen.

Jeder Prüfvorgang eines Prüfmodus umfaßt dabei die Bestimmung einer Vielzahl von für die Eigenschaften des zu prüfenden Produkts charakteristischen Parametern bzw. Kennwerten (beispielsweise mechanische, elektrische oder optische Kennwerte), die in sequentiell (d.h. nacheinander) ausgeführten Meßvorgängen ermittelt werden (teilweise sind mehr als 1000 Meßvorgänge pro Prüfvorgang erforderlich), wobei die einzelnen Meßvorgänge eines Prüfvorgangs üblicherweise auf einem rechnergesteuerten Meßautomaten ausgeführt werden. Aufgrund der Streuungen beim Herstellungsprozeß (stark streuende Prozeßschritte) und den oftmals hohen Qualitätsanforderungen sollten die zu prüfenden Produkte einer vollständigen Prüfung unterzogen werden. Diese vollständige Prüfung erfordert aber die Ausführung aller Meßvorgänge eines Prüfvorgangs, was jedoch (insbesondere bei mehreren Prüfmodi eines Herstellungsprozesses) mit hohen Kosten verbunden ist (teilweise muß für die Prüfung eines Produkts die Hälfte der Herstellungskosten veranschlagt werden).

In der Literaturstelle Milor; L., Sangiovanni-Vincentelli, A.L., "Minimizing Production Test Time to Detect Faults in Analog Circuits", IEEE Transactions on Computer-Aided Design of Integrated Circuits and Systems, Vol. 13, No. 6, June 1994, S. 796-813, wird ein Verfahren zur Prüfung von Produkten beschrieben, bei dem in einem bestimmten Prüfmodus eine Variation der Reihenfolge der Meßvorgänge eines Prüfvorgangs im Hinblick auf die Zeitdauer des Prüfvorgangs sowie die Auswahl einer Teilmenge von Meßvorgängen aus der Gesamtheit aller Meßvorgänge eines Prüfvorgangs im Hinblick auf die Qualitätsanforderungen des Prüfmodus vorgenommen wird; hierbei wird aufgrund von Statistikinformationen mittels eines Algorithmus eine Teilmenge von Meßvorgängen ermittelt und die Teilmenge so gewählt, daß eine gewünschte Ausbeute erreichbar ist. Nachteilig ist, daß das Verfahren nur dann anwendbar ist, wenn die einzelnen Meßvorgänge eines Prüfvorgangs in ihrer Reihenfolge beliebig vertauschbar sind (also keinerlei Abhängigkeit zwischen einzelnen Meßvorgängen besteht) und daß die Prüfung der Produkte innerhalb des sukzessiven Prüfungsablaufs eines Prüfmodus mit immer der gleichen Teilmenge der Meßvorgänge erfolgt, was zum Verlust von statistischen Informationen für die Meßvorgänge eines Prüfvorgangs für diesen Prüfungsablauf und folgende Prüfungsabläufe führt.

Es ist die Aufgabe der Erfindung, ein Verfahren zur Prüfung einer Vielzahl von Produkten anzugeben, das diese Nachteile vermeidet und das universell bei allen zu prüfenden Produkten anwendbar ist.

Diese Aufgabe wird erfindungsgemäß durch die Merkmale im Kennzeichen des Patentanspruchs 1 gelöst.

Vorteilhafte Weiterentwicklungen und Ausgestaltungen des Verfahrens sind Bestandteil der weiteren Patentansprüche.

Das vorgestellte Verfahren generiert für jeden Prüfmodus einen Prüfungsablauf mit sukzessiven Prüfvorgängen unter Berücksichtigung von statischen Informationen zurückliegender Prüfvorgänge (beispielsweise von früheren Herstellungsprozessen) mit
- einer bei allen Prüfvorgängen des Prüfungsablaufs eines Prüfmodus gleichen Vorgabe der Reihenfolge der Meßvorgänge, die hinsichtlich Fehlerhäufigkeit pro Meßzeit und funktionaler Abhängigkeiten zwischen den Meßvorgängen vorgegeben wird; insbesondere werden die Meßvorgänge unter Berücksichtigung der funktionalen Abhängigkeiten zwischen den Meßvorgängen in der Reihenfolge ihrer Fehlerhäufigkeit pro Meßzeit geordnet, so daß Meßvorgänge mit hoher Fehlerhäufigkeit pro Meßzeit zu Beginn eines Prüfvorgangs durchgeführt und demzufolge potentiell auftretende Fehler frühzeitig in kürzester Meßzeit erkannt werden,
- der Zuordnung eines Meßmodus für jeden Prüfvorgang eines Produkts, der bei jedem zu prüfenden Produkt in Abhängigkeit der Anzahl der bereits geprüften Produkte eines Prüfungsablaufs und deren Prüfergebnis vorgegeben wird, d.h. der Prüfungsablauf wird in jedem Prüfmodus adaptiv an das Prüfergebnis (und demzufolge an die Fehlerhäufigkeit bzw. Fehlerverteilung) der Produkte eines Prüfungsablaufs angepaßt. Die Meßmodi der einzelnen Prüfvorgänge innerhalb des sukzessiven Prüfungsablaufs eines Prüfmodus unterscheiden sich hierbei in der Anzahl der bezüglich der Gesamtheit der Meßvorgänge eines Prüfvorgangs ausgeführten Meßvorgänge, d.h. es werden nicht bei jedem zu prüfenden Produkt alle Meßvorgänge eines Prüfvorgangs durchgeführt.

Die Anzahl der Meßvorgänge eines Meßmodus und die Abfolge der verschiedenen Meßmodi innerhalb des sukzessiven Prüfungsablaufs kann nach Maßgabe bestimmter Kriterien unterschiedlich vorgegeben werden; beispielsweise hinsichtlich einer Minimierung der durch die Funktionsprüfung beeinflußten Herstellungskosten des Produktes oder hinsichtlich der Gewährleistung einer garantierten maximalen Anzahl an fehlerhaften Produkten mit negativem Prüfergebnis (Ausschußrate) oder hinsichtlich des Vermeidens von Datenverlusten bzw. statistischen Informationen. Insbesondere wird die Abfolge der Meßmodi in Abhängigkeit der Anzahl bereits geprüfter Produkte eines Prüfungsablaufs (also in Abhängigkeit von der Anzahl der bereits erfolgten Prüfvorgänge innerhalb des Prüfungsablaufs) und des Prüfergebnisses der bereits geprüften Produkte (also in Abhängigkeit von der Verteilung der Produkte mit positivem oder negativem Prüfergebnis innerhalb des Prüfungsablaufs) vorgegeben. Vorzugsweise werden jedem Prüfvorgang eines Prüfmodus alternativ zwei unterschiedliche Meßmodi zugeordnet: entweder ein Gesamt-Meßmodus, bei dem alle Meßvorgänge eines Prüfvorgangs ausgeführt werden oder ein Teil-Meßmodus, bei dem eine fest vorgegebene Teilmenge der Meßvorgänge eines Prüfvorgangs ausgeführt wird. Der Gesamt-Meßmodus wird bei einer bestimmten Anzahl an aufeinanderfolgenden Prüfvorgängen des Prüfungsablaufs vorgegeben: zu Beginn des Prüfungsablaufs, nach dem Prüfvorgang eines Produktes mit negativem Prüfergebnis und nach mehreren Prüfvorgängen von Produkten mit positivem Prüfergebnis - beispielsweise zu Beginn des Prüfungsablaufs bei zwei aufeinanderfolgenden Prüfvorgängen, also den ersten beiden Prüfvorgängen des Prüfungsablaufs, den ersten beiden auf den Prüfvorgang eines Produkts mit negativem Prüfergebnis folgenden Prüfvorgängen und nach dem auf den Prüfvorgang dreier Produkte mit positivem Prüfergebnis folgenden Prüfvorgang, also beim Prüfvorgang jedes vierten Produkts.

Das vorgestellte Verfahren vereinigt mehrere Vorteile in sich:
- es ist reproduzierbar und mathematisch belegt, da der Prüfungsablauf auf der Grundlage statistischer Informationen ohne empirischen Einfluß oder subjektive Entscheidungen gesteuert wird; somit ist es weitgehend automatisierbar, ohne daß aufwendige Einstellarbeiten erforderlich sind,
- es ist sicher, da ein Verlust der statistischen Informationen über einzelne Meßvorgänge oder Prüfvorgänge innerhalb eines Prüfungsablaufs, über die verschiedenen Prüfungsabläufe eines Prüfmodus und über verschiedene Prüfmodi und somit über das Produktverhalten in der laufenden Produktion vermieden wird: alle Kenngrößen des Prüfvorganges (Meßzeit, Ausbeute, Kosten, etc.) eines Prüfmodus können mit ihrer Streuung vor Beginn des Prüfungsablaufs bestimmt und während des Prüfungsablaufs durch die Prüfergebnisse der bereits geprüften Produkte ergänzt bzw. kontrolliert werden, so daß bei jedem Prüfmodus für alle Prüfvorgänge des Prüfungsablaufs eine (automatisch angepaßte, von der Fehlerhäufigkeit bzw. Ausbeute der zu prüfenden Produkte nicht abhängige) statistische Grundlage gewährleistet ist und eine automatische Adaption an sich verändernde Charakteristiken des Herstellungsprozesses der Produkte erfolgt; hierdurch wird überdies die Einhaltung der vorgegebenen Anforderungen an die Qualität des Produkts über den gesamten Zeitraum der Produktion eines bestimmten Produkts oder verschiedener Produkttypen gewährleistet,
- es ist eine Optimierung hinsichtlich frei wählbarer Kriterien möglich, beispielsweise hinsichtlich einer Minimierung der Herstellungskosten oder der Meßzeiten bei vorgegebener Qualität des Produktes.

Das Verfahren soll im folgenden anhand eines Ausführungsbeispiels beschrieben werden, der Prüfung von Halbleiterbauelementen während des Herstellungsprozesses. Im Verlauf des Herstellungsprozesses der Halbleiterbauelemente wird beispielsweise ein mehrere nacheinander ausgeführte Meßvorgänge umfassender Prüfvorgang der Halbleiterelemente auf der Halbleiterscheibe (dem Wafer) in einem Prüfmodus als sogenanntes "Proben" und ein mehrere nacheinander ausgeführte Meßvorgänge umfassender Prüfvorgang beim fertig montierten und aufgebauten Halbleiterbauelement in einem Prüfmodus als sogenanntes "Endmessen" vorgenommen.

Bei beiden Prüfmodi wird jedem Prüfvorgang innerhalb des Prüfungsablaufs hierbei als Meßmodus entweder ein Gesamt-Meßmodus mit der kompletten Anzahl an Meßvorgängen oder ein Teil-Meßmodus mit einer reduzierten Anzahl an Meßvorgängen zugeordnet. Die Anzahl der Meßvorgänge des Teil-Meßmodus und die Abfolge der beiden Meßmodi im Prüfungsablauf werden bei den beiden genannten Prüfmodi unterschiedlich vorgegeben: beim Prüfmodus Proben wird eine Minimierung der durch die Prüfung verursachten Kosten angestrebt, beim Prüfmodus Endmessen dagegen die Einhaltung einer garantierten maximalen Ausschußrate (minimale Fehlerhäufigkeit).

Bei beiden Prüfmodi wird eine bestimmte Abfolge der Meßmodi in Abhängigkeit von der Zahl der Prüfvorgänge und von der Verteilung der Produkte mit negativem Prüfergebnis (fehlerhafte Produkte) innerhalb des Prüfungsablaufs vorgegeben:
- den beiden ersten Prüfvorgängen eines Prüfungsablaufs und anschließend jedem vierten Prüfvorgang wird der Gesamt-Meßmodus zugeordnet; man erhält somit eine Prüf-Sequenz aus 2xGesamt-Meßmodus, 3xTeil-Meßmodus, 1xGesamt-Meßmodus, 3xTeil-Meßmodus etc.
- beim Auftreten eines Produkts mit negativem Prüfergebnis (fehlerhaftes Produkt) wird die Prüf-Sequenz von vorne begonnen, d.h. den nächsten beiden Prüfvorgängen wird der Gesamt-Meßmodus zugeordnet (2xGesamt-Meßmodus); demzufolge wird beim Auftreten mehrerer fehlerhafter Produkte in Folge nach dem Erkennen eines dieser fehlerhaften Produkte auch bei allen folgenden Produkten ein Prüfvorgang mit allen Meßvorgängen durchgeführt - diese Produkte werden somit sicher als fehlerhaft erkannt, d.h. in Bereichen mit geringer Ausbeute werden alle Produkte vollständig verifiziert
- bei einem positiven Prüfergebnis zweier aufeinanderfolgender Prüfvorgänge (zwei fehlerfreie Produkte in Folge) wird wieder zur normalen Prüf-Sequenz 3xTeil-Meßmodus, 1xGesamt-Meßmodus, 3xTeil-Meßmodus etc. übergegangen.

Die Ergebnisse für die beiden Prüfmodi Proben und Endmessen werden am Beispiel eines integrierten Schaltkreises (ICs) für den Kfz-Bereich erläutert, einem Analog-/Digital-IC für Dimmer-Anwendungen.

Beim Herstellungsprozeß der integrierten Schaltkreise IC (Herstellungskosten ca. 0,79 DM pro IC) werden die auf einem 4''-Silizium-Wafer angeordneten Halbleiterelemente (beispielsweise 840 Halbleiterelemente mit den Abmessungen 3,54 mm x 2,07 mm) mittels einer Standard Bipolar-Technologie bearbeitet und die bearbeiteten Halbleiterelemente mit einem DIP-Gehäuse mit 8 Anschlüssen versehen. Im Ablauf des Herstellungsprozesses werden bei den Halbleiterelementen zwei Prüfmodi mit drei Prüfvorgängen durchgeführt: ein Prüfvorgang bei den Halbleiterelementen eines Wafers (Prüfmodus Proben), beispielsweise mit 40 nacheinander durchgeführten Meßvorgängen bei einer Temperatur von 25°C, und zwei Prüfvorgänge bei den fertig montierten Halbleiterelementen (Prüfmodus Endmessen), beispielsweise ein Prüfvorgang mit 37 nacheinander durchgeführten Meßvorgängen bei einer Temperatur von 110°C und ein Prüfvorgang mit 36 nacheinander durchgeführten Meßvorgängen bei einer Temperatur von -40 °C. Hierbei beträgt die Meßzeit pro fehlerfreiem Prüfvorgang, d.h. bei Durchführung aller Meßvorgänge, ca. 1,2 s.

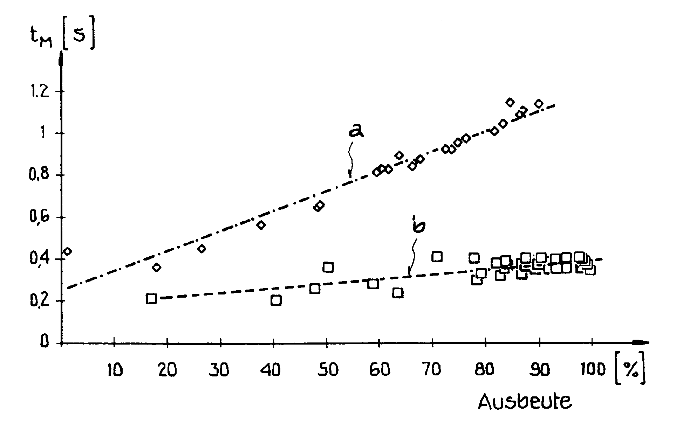

Beim Prüfmodus Proben wurde die Reihenfolge der Meßvorgänge erfindungsgemäß variiert und neben dem Gesamt-Meßmodus ein Teil-Meßmodus mit lediglich 5 Meßvorgängen herangezogen. In der Figur sind die Meßzeiten t_{M} (und damit die Kosten) in Abhängigkeit der Ausbeute (prozentualer Anteil der fehlerhaften Produkte) bei der Funktionsprüfung mit einem konventionellen Verfahren (Kurve a) und mit dem vorgestellten Verfahren (Kurve b) einander gegenübergestellt. Wie dieser Vergleich zeigt, ist beim vorgestellten Verfahren (Kurve b) eine deutliche Reduzierung der Meßzeit t_{M} gegeben, wobei der Prüfvorgang in Bereichen mit geringer Ausbeute (viele fehlerhafte Produkte) aufgrund der gewählten Reihenfolge der Meßvorgänge und in Bereichen mit hoher Ausbeute (wenig fehlerhafte Produkte) aufgrund der geringen Anzahl an durchgeführten Meßvorgängen (Zuordnung vieler Teil-Meßmodi) schneller beendet wird. Die durch die Reduzierung der Meßzeit t_{M} eingesparten Kosten betragen insgesamt ca. 0,03 DM pro IC, d.h. bei den gesamten Herstellungskosten von ca. 0,79 DM pro IC ergibt sich hierdurch eine Reduzierung der Herstellungskosten von ca. 4 %.

Beim Prüfmodus Endmessen wurde mit der Vorgabe einer maximalen Ausschußrate von 200 ppm (d.h. maximal 200 fehlerhafte auf 1 Million geprüfter Halbleiterbauelemente) bei einer Sicherheit von 95 % die Reihenfolge der Meßvorgänge erfindungsgemäß variiert und neben dem Gesamt-Meßmodus mit allen 36 bzw. 37 nacheinander durchgeführten Meßvorgängen ein Teil-Meßmodus mit 31 Meßvorgängen herangezogen. Die durch die Reduzierung der Meßzeit von ca. 80 ms pro IC eingesparten Kosten betragen 0,0032 DM pro IC, wobei die Entdeckungswahrscheinlichkeit fehlerhafter ICs 99,89 % und die Ausschußrate 33 ppm beträgt.

## Patentansprüche

1. Verfahren zur Prüfung einer Vielzahl von Produkten, wobei jedes zu prüfende Produkt mindestens einem Prüfmodus unterzogen wird, der in einem Prüfungsablauf sukzessive bei allen Produkten mittels eines jeweils mehrere nacheinander ausgeführte Meßvorgänge umfassenden Prüfvorgangs für jedes zu prüfende Produkt durchgeführt wird und bei dem jedem geprüften Produkt ein Prüfergebnis zugeordnet wird, wobei bei jedem Prüfmodus die Reihenfolge der Meßvorgänge eines Prüfvorgangs derart vorgegeben wird, dass die Meßvorgänge unter Berücksichtigung ihrer Fehlerhäufigkeit pro Meßzeit und der funktionalen Abhängigkeiten zwischen den Meßvorgängen geordnet werden,
**dadurch gekennzeichnet, dass**:
• jedem Prüfvorgang innerhalb des Prüfungsablaufs eines Prüfmodus ein Meßmodus aus einer Anzahl von Meßmodi zugeordnet wird, der eine bestimmte Anzahl an auszuführenden Meßvorgängen aufweist und
• die Zuordnung des Meßmodus für jeden Prüfvorgang in Abhängigkeit der Anzahl und der Prüfergebnisse der bereits geprüften Produkte eines Prüfungsablaufs zur Berücksichtigung statistischer Informationen des Prüfvorgangs bereits geprüfter Produkte dynamisch während des Prüfungsablaufs erfolgt.

2. Verfahren nach Anspruch 1, **dadurch gekennzeichnet, daß** bei jedem Prüfmodus die Meßvorgänge eines Prüfvorgangs unter Berücksichtigung der funktionalen Abhängigkeiten zwischen den Meßvorgängen ihrer Fehlerhäufigkeit pro Meßzeit nach zeitlich derart geordnet werden, daß Meßvorgänge mit großer Fehlerhäufigkeit pro Meßzeit zu Beginn des Prüfvorgangs ausgeführt werden.

3. Verfahren nach Anspruch 1 oder 2, **dadurch gekennzeichnet, daß** jedem Prüfvorgang innerhalb des Prüfungsablaufs eines Prüfmodus als Meßmodus entweder ein Gesamt-Meßmodus, bei dem alle Meßvorgänge eines Prüfvorgangs ausgeführt werden oder ein Teil-Meßmodus, bei dem eine Teilmenge der Meßvorgänge eines Prüfvorgangs ausgeführt wird, zugeordnet wird.

4. Verfahren nach Anspruch 3, **dadurch gekennzeichnet, daß** im Teil-Meßmodus die Teilmenge der Meßvorgänge eines Prüfvorgangs in Abhängigkeit der durch den Prüfvorgang beeinflußten Kosten und/oder der garantierten maximalen Fehlerhäufigkeit des Prüfmodus festgelegt wird.

5. Verfahren nach Anspruch 3 oder 4, **dadurch gekennzeichnet, daß** der Gesamt-Meßmodus einer bestimmten Anzahl von Prüfvorgängen zu Beginn des Prüfungsablaufs eines Prüfmodus und von auf ein Produkt mit negativem Prüfergebnis folgenden Prüfvorgängen zugeordnet wird.

6. Verfahren nach Anspruch 5, **dadurch gekennzeichnet, daß** der Gesamt-Meßmodus den beiden ersten Prüfvorgängen des Prüfungsablaufs eines Prüfmodus und den beiden auf ein Produkt mit negativem Prüfergebnis folgenden Prüfvorgängen zugeordnet wird.

7. Verfahren nach einem der Ansprüche 3 bis 6, **dadurch gekennzeichnet, daß** der Gesamt-Meßmodus dem auf eine bestimmte Anzahl von Produkten mit positivem Prüfergebnis folgenden Prüfvorgang zugeordnet wird.

8. Verfahren nach Anspruch 7, **dadurch gekennzeichnet, daß** der Gesamt-Meßmodus dem auf drei Produkte mit positivem Prüfergebnis folgenden Prüfvorgang zugeordnet wird.

## Claims

1. Method of checking a plurality of products, wherein each product to be checked is subjected to at least one checking mode which is carried out in a checking sequence successively for all products by means of a checking process, which comprises a plurality of successively executed measuring processes and in which statistical data of the checking process of already checked products are taken into consideration and in which a check result is associated with each checked product, **characterised in that**:
- in each checking mode the sequence of measuring processes of a checking process is predetermined in such a manner that the measuring processes are ordered with consideration of their error frequency per measuring time and the functional dependencies between the measuring processes,
- each checking process within the checking sequence of a checking mode is associated with a measuring mode which has a specific number of measuring processes to be executed and which is predetermined in dependence on the number and the check results of the already checked products of a checking sequence.

2. Method according to claim 1, **characterised in that** in each checking mode the measuring processes of a checking process are ordered according to time with consideration of the functional dependencies between the measuring processes [...] their error frequency per measuring time in such a manner that the measuring processes with greater error frequency per measuring time are executed at the beginning of the checking process.

3. Method according to claim 1 or 2, **characterised in that** each checking process within the checking sequence of a checking mode is associated with, as measuring mode, either a total measuring mode in which all measuring processes of a checking process are executed or a part measuring mode in which a part number of the measuring processes of a checking process is executed.

4. Method according to claim 3, **characterised in that** in the part measuring mode the part number of the measuring processes of a checking process is fixed in dependence on the costs influenced by the checking process and/or the guaranteed maximum error frequency of the checking mode.

5. Method according to claim 3 or 4, **characterised in that** the total measuring mode is associated with a specific number of checking processes at the start of the checking sequence of a checking mode and of checking processes following a product with negative check result.

6. Method according to claim 5, **characterised in that** the total measuring mode is associated with the two first checking processes of the checking sequence of a checking mode and with the two checking processes following a product with negative check result.

7. Method according to one of claims 3 to 6, **characterised in that** the total measuring mode is associated with the checking process following a specific number of products with positive check result

8. Method according to claim 7, **characterised in that** the total measuring mode is associated with the check process following three products with positive check result.

## Revendications

1. Procédé de contrôle d'une quantité multiple de produits, dans lequel chaque produit à contrôler est soumis à au moins un mode de contrôle qui est exécuté dans le cadre d'un déroulement de contrôle successivement pour tous les produits au moyen d'un processus de contrôle comprenant à chaque fois plusieurs processus de mesure effectués les uns après les autres pour chaque produit à contrôler, et dans lequel on associe un résultat de contrôle à chaque produit contrôlé, procédé dans lequel on prédéfinit la succession des processus de mesure d'un processus de contrôle pour chaque mode de contrôle de telle façon que les processus de mesure soient ordonnés en tenant compte de leur fréquence d'erreurs par temps de mesure et des dépendances fonctionnelles entre les processus de mesure, **caractérisé en ce que** :
. l'on associe à chaque processus de contrôle à l'intérieur du déroulement de contrôle d'un mode de contrôle un mode de mesure choisi parmi une pluralité de modes de mesure présentant un nombre défini de processus de mesure à effectuer, et
. l'association du mode de mesure pour chaque processus de contrôle s'effectue de manière dynamique durant le déroulement de contrôle en fonction du nombre et des résultats de contrôle des produits déjà contrôlés d'un déroulement de contrôle pour la prise en compte d'informations statistiques du processus de contrôle de produits déjà contrôlés.

2. Procédé selon la revendication 1, **caractérisé en ce que** pour chaque mode de contrôle les processus de mesure d'un processus de contrôle sont ordonnés dans le temps selon leur fréquence d'erreurs par temps de mesure, en tenant compte des dépendances fonctionnelles entre les processus de mesure, de telle manière que les processus de mesure sont effectués avec une fréquence d'erreurs importante par temps de mesure au début du processus de contrôle.

3. Procédé selon la revendication 1 ou 2, **caractérisé en ce que** comme mode de mesure on associe à chaque processus de contrôle à l'intérieur du déroulement de contrôle d'un mode de contrôle, soit un mode de mesure global, dans le cadre duquel on effectue tous les processus de mesure d'un processus de contrôle, soit un mode de mesure partiel, dans le cadre duquel on effectue une partie des processus de mesure d'un processus de contrôle.

4. Procédé selon la revendication 3, **caractérisé en ce que** l'on détermine dans le mode de mesure partiel la partie des processus de mesure d'un processus de contrôle en fonction des coûts induits par le processus de contrôle et/ou de la fréquence d'erreurs maximale garantie du mode de contrôle.

5. Procédé selon la revendication 3 ou 4, **caractérisé en ce que** le mode de mesure total est associé à un nombre défini de processus de contrôle au début du déroulement de contrôle d'un mode de contrôle et de processus de contrôle suivant un produit à résultat de contrôle négatif.

6. Procédé selon la revendication 5, **caractérisé en ce que** le mode de mesure global est associé aux deux premiers processus de contrôle du déroulement de contrôle d'un mode de contrôle et aux deux processus de contrôle suivant un produit à résultat de contrôle négatif.

7. Procédé selon l'une quelconque des revendications 3 à 6, **caractérisé en ce que** le mode de mesure global est associé au processus de contrôle suivant un nombre défini de produits à résultat de contrôle positif.

8. Procédé selon la revendication 7, **caractérisé en ce que** le mode de mesure global est associé au processus de contrôle suivant trois produits à résultat de contrôle positif.
